# EUROPEAN PATENT APPLICATION

(11) **EP 1 505 375 A1**
(43) Date of publication of application: **09.02.2005**
(21) Application number: 02756014.3
(22) Date of filing: 04.04.2002
(51) Int. Cl.: G01J 1/50, C30B 33/02

(54) **METHOD FOR PRODUCING THE SENSING ELEMENT OF AN ULTRA-VIOLET INDICATOR**

(71) Applicant: Morozov, Mikhail Mikhailovich, Moscow, 103681 (RU); Titov, Anatoly Ivanovich, Moscow, 103498 (RU); Kurilov, Alexandr Nikolaevich, 141070 Moskovskaya obl. (RU); Krivoshei, Jury Viktorovich, 141070 Moskovskaya obl. (RU); Demin, Andrei Vasilievich, Moscow, 121359 (RU)
(72) Inventor: Morozov, Mikhail Mikhailovich, Moscow, 103681 (RU); Titov, Anatoly Ivanovich, Moscow, 103498 (RU); Kurilov, Alexandr Nikolaevich, 141070 Moskovskaya obl. (RU); Krivoshei, Jury Viktorovich, 141070 Moskovskaya obl. (RU); Demin, Andrei Vasilievich, Moscow, 121359 (RU)
(74) Representative: Minoja, Fabrizio, Dr.
(86) International application number: PCT/RU2002/000154
(87) International publication number: WO 2003/085367

(57) **Abstract**

The invention relates to the production of photosensitive materials and can be used for photobiology, medicine, instrument engineering and for thermal and fire protection. Ultra-violet indicators (UV-light) used for various fields must efficiently operate in various wavelength regions of UV-light. The inventive method for producing a sensing element of an ultra-violet indicator consists in growing an alkaline-halide monocrystal of the potassium group from a melt, carrying out the main annealing of said monocrystal at a temperature ranging from 500 °C to 580 °C during 4-6 hours in sodium vapours, subsequent cooling the monocrystal at a cooling rate which is equal to or less than 1 degree/min. and additionally annealing it at a temperature ranging from 500 °C to 540 °C for 90 min. in air, prior to the main annealing said monocrystal being annealed at a temperature ranging from 550 to 650 °C during 1.5-2 hours in air. Said method makes it possible to produce a reusable sensing element which is quickly and uniformly colourable when exposed to UV-light and to reduce the time of loss of colour of said sensing element.

## Description

### Field of the Invention

The invention relates to the field of production of photosensitive materials and can be used in photobiology, medicine, instrument engineering and for thermal and fire protection.

Ultraviolet detectors (UV-radiation) used for various applications must efficiently operate in different wavelength ranges of UV-radiation.

### Background of the Invention

A method for producing an ultraviolet radiation sensing element is known in the prior art (see the patent No. SU 1019490, IPC⁷ G01J 1/50), said method including growing an alkaline-halide monocrystal of the potassium series from a melt, and subjecting said monocrystal to annealing in alkaline metal vapours (matrix potassium cation) and to subsequent cooling.

The produced monocrystals of KCl:Sr and KJ:Co for sensing elements can be used in optical devices.

However, erasing of the recorded information requires heating the crystals to a temperature of 150 to 200°C for KCl:Sr and to a temperature of 300 to 350°C for KJ:Co, and this is an essential drawback.

A method for producing a sensing element of an UV-radiation detector is known in the prior art, in which method an alkaline-halide monocrystal of the potassium series is grown from a melt, then said monocrystal is subjected to a main annealing at a temperature of 500 to 580°C for 4 to 6 hours in sodium vapours. Thereafter, the monocrystal is cooled at a cooling rate of not more than 1 °/min. After the monocrystal is cooled, an additional annealing of the monocrystal is carried out in air at a temperature of 500 to 540°C for 90 minutes.

This method is considered as the closest prior art (see the International application No. PCT/RU98/00278 filed 28.08.1998, IPC⁷ G01J 1/50) to the present invention.

Drawbacks of this method are in that, when using this technique, a pronounced surface effect is observed in the sensing element having dimensions greater than 3×3×3 mm. That is, the crystal has the required sensitivity to UV-radiation exposure in a subsurface layer (< 1 mm) and the negligible sensitivity in the crystal bulk. This results in the nonuniform colouring after the UV-radiation exposure and, since the surface layer is oversaturated with anion vacancies and various impurities, a process of loosing colour (a discolouring process) upon exposure to visible light is highly hindered and the crystal poorly looses colour, and this limits the repeated use of the crystal.

### Summary of the Invention

An object of the invention is to provide a reusable sensing element which quickly and uniformly acquires colour throughout a crystal exposed to UV-radiation, as well as to reduce a colour acquisition time (a colouring time) and a colour loss time (a discolouring time) of the sensing element.

The above object is achieved by a method for producing a sensing element of an ultraviolet radiation detector, said method including growing an alkaline-halide monocrystal of the potassium series from a melt, main annealing said monocrystal at a temperature of 500 to 580°C for 4 to 6 hours in sodium vapours, followed by cooling at a cooling rate of not more than 1 °/min, and additional annealing the monocrystal in air at a temperature of 500 to 540°C for 90 minutes, wherein, prior to said main annealing, the monocrystal is subjected to annealing in air at a temperature of 550 to 650°C for 1.5 to 2 hours.

### Best Mode of Carrying Out the Invention

An alkaline-halide monocrystal of the potassium series is grown from a melt of KJ (potassium iodide) by the conventional method to obtain the following concentration of a doping additive in the form of sodium cations (wt.%): KJ - 99.9990 to 99.9999; Na - 0.001 to 0.0001, wherein the colour centers are uniformly distributed throughout the bulk of monocrystal.

Then, the monocrystal is chopped into small pieces, for example, seized as 4×4×4 mm, or 5×5×5 mm and more, or 4(10)×4(10)×2(1) mm.

The crystals are subjected to a preliminary annealing in air at the temperature of 550 to 650°C for a time period of 1.5 to 2 hours. This allows to achieve the uniform distribution of anion vacancy concentration throughout the bulk of sensing element (the crystal).

Then, a main annealing is carried out at the temperature of 500 to 580°C in alkaline metal (Na) vapours for a time period of 4 to 6 hours. The main annealing at such temperature ensures the maximal mobility of crystal lattice anions, the optimal pressure of alkaline metal vapour, and the formation of photosensitivity centers which create, upon exposure to UV-radiation, colour centers destroyable by exposing to the visible light (λₘₐₓ = 690 nm) or by heating to 450°C. This allows to repeatedly use the crystals many times.

When the main annealing temperature t < 500°C, the mobility of anions in the crystal is reduced and the work function of electrons from the metal is increased so that the formation of photosensitivity centers does not practically take place. The time of main annealing affects the depth of formation of photosensitivity centers in the crystal.

Then, the crystal is cooled at a cooling rate of not more than 1 °/min (one degree per minute). Thereafter, the crystal is annealed in air at the temperature of 500 to 540°C for 90 minutes.

When the cooling rate is more than 1 °/min, the crystal is quenched so that the crystal of blue colour is obtained. When the cooling rate ≤ 1 °/min, the coloured crystal is discoloured and the photosensitivity centers are formed.

The above-mentioned preliminary annealing (prior to the main annealing) of the sensing element (the crystal) in air saturates a surface layer of the crystal with anion vacancies which diffuse to the surface of the crystal and, after that, a slow (1.5 to 2 hours) equalization of the anion vacancy concentration proceeds over the whole bulk of the crystal, thereby improving the crystal properties such as the reduced time of colour acquisition and the reduced time of colour loss when the crystal is exposed to UV-radiation.

When the temperatures of said preliminary annealing are equal to or more than 550°C, the diffusion rate of anion vacancies to the crystal surface is increased. But, when the preliminary annealing temperatures are higher than 650°C, the irreversible plastic deformations begin to occur in the KJ crystal. Thus, the above chosen temperature range for said preliminary annealing of the crystal (the sensing element) in air is optimal.

In the closest prior art, when alkaline metal vapour is present, electrons quickly penetrate into a subsurface layer enriched with the anion vacancies. The activation energy for this process is 0.5 eV and the process rate, according to different estimates, is 1.5 to 2 times higher than the migration rate of anion vacancies. As a result, there appears a layer having the thickness of about 1 mm and exhibiting the limiting concentration of F centers, and namely this layer stops the slow process of vacancy concentration equalization within the crystal bulk, because it prevents the halogen from being diffused to the surface by the vacancy mechanism. In the closest prior art, this subsequently results in the pronounced surface effect in terms of sensitivity to UV-radiation and, therefore, to the deterioration of sensing element performance with respect to the colour acquisition and the subsequent colour loss.

The crystals of KJ:Na according to the present invention are photosensitive at the room temperature to the exposure of UV-radiation having a wavelength of 280 to 320 nm and they acquire a blue colour at the threshold value of exposition.

### Industrial applicability

The present invention can be most effectively used in photobiology, medicine, when getting a sunburn in the natural sun and in solaria to visually determine the intensity of UV-radiation.

Further, the present invention can be used in various devices for thermal protection and fire protection.

The present invention can be also used in devices for ultraviolet protection of the electronic and optical equipment.

## Claims

1. A method for producing a sensing element of an ultraviolet radiation detector, said method including growing an alkaline-halide monocrystal of the potassium series from a melt, main annealing the monocrystal at a temperature of 500 to 580°C for 4 to 6 hours in sodium vapours, followed by cooling at a cooling rate of not more than 1 °/min, and additional annealing the monocrystal in air at a temperature of 500 to 540°C for 90 minutes, **characterised in that**, prior to said main annealing, the monocrystal is subjected to annealing in air at a temperature of 550 to 650°C for 1.5 to 2 hours.
